# EUROPEAN PATENT APPLICATION

(11) **EP 3 306 625 A1**
(43) Date of publication of application: **11.04.2018**
(21) Application number: 16460075.1
(22) Date of filing: 05.10.2016
(51) Int. Cl.: H01F 27/08, H01F 27/36, H01L 23/34, H01L 23/60, H01H 9/48, G05F 1/20, H05K 7/20, H05K 9/00, H01F 29/02

(54) **CONDUCTIVE SCREEN FOR POWER ELECTRONIC ELEMENTS ENCLOSED IN AN INSULATING MEDIUM**

(71) Applicant: ABB Schweiz AG, 5400 Baden (CH)
(72) Inventor: Grecki, Filip, 31-421 Krakow (PL); Aloszko, Pawel, 31-421 Krakow (PL); Piasecki, Wojciech, 31-347 Krakow (PL); Czyzewski, Jan, 30-376 Krakow (PL); Ostrogorska, Magdalena, 31-324 Krakow (PL)
(74) Representative: Chochorowska-Winiarska, Krystyna

(57) **Abstract**

The subject of the invention is a conductive screen for power electronic elements enclosed in insulating medium and working on high voltage potential having an application in energetic industry, specially designed for HV transformer. Conductive is characterized in that the power electronic element (1) is electrically connected with a heat radiator (8) having an external surface (8a) and a first conductive screen (10) is placed on the surface (8a) of the radiator (8). The first conductive screen is electrically connected with high voltage potential derived through a HV terminal (3). The conductive screen is adapted for shaping an electric field distribution between the potential of the screen (10) and a ground potential of the housing (5) filled-in with the insulating medium (6). The screen (10) is attached to the flat surface (8a) of the heat radiator (8) in such a way that the sharp edges of the radiator (8) and the power electronic device (1) are encircled by the screen (10) and a second conductive screen (10') is placed in the insulating medium (6) and the second screen (10') is electrically connected with the first screen (10).

## Description

The subject of the invention is a conductive screen for power electronic elements enclosed in insulating medium and working on high voltage potential having an application in energetic industry, specially designed for HV transformer.

The field shaping screens are well known and broadly applied in HV applications, e.g. cable connectors, bushings, current transformers, etc. In those applications, the screen has to be connected to either potential (ground, high or some other well defined). The role of the screen is to shape an uniform electric field, so that the local material stress is minimized.

In solid insulation, there is a matter of materials dielectric constant parameter. The higher the dielectric constant, the more electric field is pushed to any voids in the insulation materials, causing deterioration of insulation properties and leading to premature material breakdown. This phenomena is further intensified by any sharp edges or points, where the electric field is amplified. Solution to even, smooth field distribution is an electrically conducting screen.

Application of low voltage solid state switching elements (i.e. power electronic elements) designed as functional module for high voltage application, require insulation medium, whether solid (e.g. epoxy resin or silicone) or liquid (e.g. insulation oil). The power electronic elements (PE) encapsulated or casted in solid state insulation material face difficulty in dissipating heat, due to low heat conductivity of insulating materials. Moreover, locally accumulated heat may cause not only PE damage, but also lead to delamination from solid state insulation of elements on high voltage potential, causing local conditions for partial discharge (PD). The PD then further causes insulation derating with potential dangers for utility and possible damage of the whole device. Any imperfection in insulation material will be multiplied by high potential electrodes, i.e. edges, spikes, sharp elements, thin leads, thin layers, which all may be normally constituting the elements working on high potential. Therefore, the conducting screen is applied, to manage and shape the electric field distribution.

For the cooling matter, the power electronic elements need heat dissipation. The best results are obtained with high surface copper or aluminum radiators, which often have sophisticated shapes. It is quite common, that the radiators have sharp edges, are cut out of preformed blocks or are made of material sheets. Those sharp edges are a potential spot for electric field amplification. While molded in the solid dielectric material there is also a risk of de-lamination between the metallic radiator and the encapsulating dielectric material. In such a case air void is created which results in unacceptable partial discharge level.

There is know from US granted patent US 6757181 a molded shield structure having a metal shield to protect sensitive devices on the printed circuit boards. The structure comprising a printed board, a die attached to the printed circuit board, a post attached on the printed circuit board and a shield secured to the post by pressing shield against the post. The die and the post is enclosed by the shield. The shield can be, for example, made of stainless steel, copper, or a copper alloy. A mold compound encapsulates the shield, the post and the die. Such molded structure is designed for protection electronic devices from electric fields emanating from other devices present on the circuit board or from the surrounding environment. The posts attached on the printed circuit are connected to ground through interconnect and can be solid copper, aluminum, or solder-coated ceramic. This screen does not solve the problem of electric field shaping, for elements on high potential in reference to ground potential, as well as not improve the effectiveness of the radiators.

The essence of the invention is that power electronic element or elements are electrically connected with a heat radiator, which radiator has an external surface on which the first conductive screen is placed. The radiator is electrically connected with high voltage potential derived through HV terminal. The first conductive screen is adapted for shaping an electric field distribution between the potential of the screen and a ground potential of the housing filled-in with the insulating medium. The first screen is attached to the external surface of the heat radiator in such a way that the sharp edges of the radiator and the power electronic device are encircled by the screen. The additional second conducting screen is placed in the insulating medium and the second screen is electrically connected with the first screen.

Preferably power electronic elements are placed on two opposite side of the base structure and first screens placed on the radiators are electrically connected with themselves through the additional second screen.

Preferably the radiator is made of copper or copper alloy or aluminum.

Preferably the first and the second screens are carried out as a mesh or a perforated sheet.

Preferably the first and second screens are made of copper, cooper alloy, brass, aluminum or a composite electrically conductive material.

Preferably the second screen is provided with the window or windows for placing in it the control terminals.

Preferably the insulating medium is a solid state medium such as epoxy resin, silicone or thermoplastic.

Alternatively the insulating medium is liquid or gaseous medium.

Preferably the housing has a form of a solid steel structure, a structure assembled from metal sheets or a metal mesh.

Conductive screen for power electronic elements enclosed in an insulating medium according to claims 1-8 is used in a tap changer of a high voltage transformer.

A tap changer having a screen according to any of claims 1-8 has at least one of the power electronic element such as a thyristor, IGBT transistor, MOSFET transistor, GTO thyristor, diode or other power semi-conductive element.

The main benefit of the invention is the possibility to design a base structure such as printed board with power electronic elements enclosed in insulating medium and working on high voltage potential in an improved way. The screen allows for obtaining an even electric field distribution in any insulation medium, whether solid, liquid or gaseous. The screen eliminates local high stress of insulation medium. In the case when a solid insulation is used the risk of de-lamination between the metallic elements and the solid insulation in the high electric field area is eliminated. At the same time the risk of PDs (Partial Discharge) generation due to the de-lamination is avoided. Using the radiators connected to the power electronic elements the condition of heat sinking (cooling) are improved. The heat is efficiently absorbed from semi conductive elements and the insulation properties of the material are not compromised. The screen also works as heat distribution element, improving the effectiveness of radiators. In power electronics placed in solid insulation, there is a joined issue of cooling and screening the power electronic elements. Thus, any sharp edges, thin metal layers or even assembly imperfections do not pose risk to electric discharge.

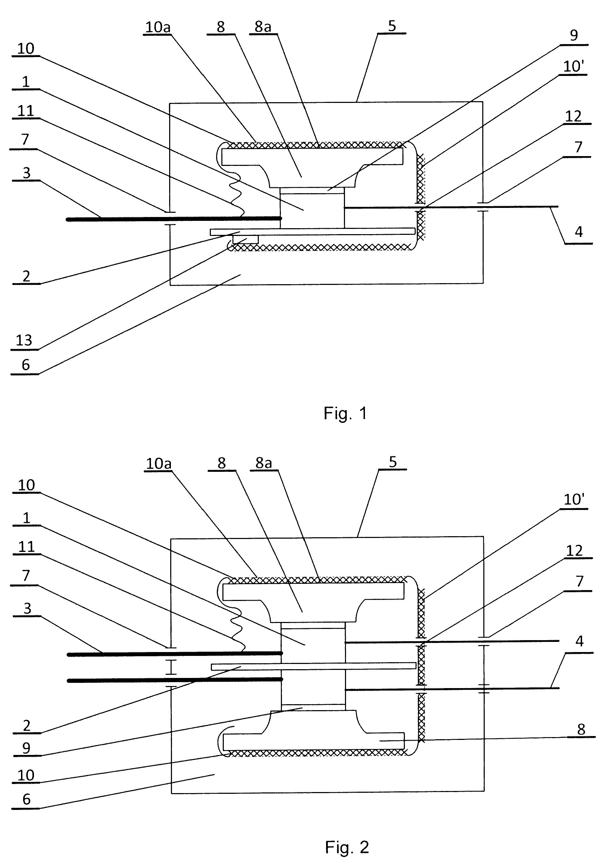

The subject of the invention is presented as an embodiment in the drawing where: fig. 1 shows a conductive screen overlapping the power electronic device placed on the base structure in a first embodiment of the invention,

fig. 2 shows a conductive screen overlapping the power electronic devices placed on the base structure in a second embodiment of the invention.

In the exemplary embodiment of the invention at least one power electronic element 1 is placed on the base structure 2. The power electronic elements could be a thyristor, IGBT transistor, MOSFET transistor, GTO thyristor, diode or other power semi-conductive element. The base structure 2 is a printed circuit board and on this board at least one passive device is placed what is not indicated on the drawing. The electronic element or elements, if there are more than one are place on the base structure 2, are connected with a HV terminal 3 and a control terminal 4. The high voltage terminal 3 is a lead or a cable connecting the power electronic element 1 to the switched circuit, not presented in the drawing. The control terminal 4 is either electric or galvanic connection for signal controlling device, not presented in the drawing. The electronic element 1 and the base structure 2 are placed inside the housing 5 being in the ground potential and filled with the insulation medium 6. The insulation medium could be an oil, the solid insulator or gas medium. The terminals 3 and 4 are placed in the bushings 7 inserted to the wall of the housing 5. The power electronic element 1 is connected with a metal radiator 8 through an insulation spacer 9, inserted between the electronic element 1 and radiator 8. If there are more than one electric element on the base stricture 2 all electronic elements are connected with the same radiator 8. The insulation spacer 9 is made with electrically insulating material having a good heat conductive properties such as aluminum oxide.

The radiator 8 is made of metal and has an external surface 8a on which a conductive metal first screen 10 is placed. The conductive screen 10 is preferably made from copper, cooper alloy, brass, aluminum or a composite electrically conductive material and has an electrical connection 11 with the HV terminal 3, setting the potential of the screen 10. The conductive screen 10 is mechanically and electrically connected to the radiator 8. The conducting screen 10 is shaped in such way, that it creates an external surface 10a towards metal housing 5, which is on ground potential. In general the surface 10a is placed parallel to the wall of the housing 5. The surface 10a and the part of the surface of the housing parallel to the surface 10a make a pair of electrodes allowing to minimize electric field stress on the insulation material 6. The conductive screen it is carried out as a mesh or a perforated sheet. The conductive screen 10 is fixed to the radiator 8 in such way, that it is galvanicaly connected with radiator in order to have electric and heat conductive contact. The screen 10 encircles or overlapping the power electronic element or elements, the radiator 8 and also the other elements on high potential, which could have sharp edges or points, which are placed on the base structure 2 and not presented on the drawing. As the flat surface 10a is design for shaping the electric field distribution it is convenient to use it also in other arrangement in the insulating medium 6.

In the first embodiment of the invention (fig.1) the electronic element or elements are placed only for one side of the base structure 2. In such embodiment the first screen 10 is overlapping the radiator 8 and extend on the side of the control terminal 4 by a second screen 10' in order to overlap the base structure 2 from its external side. In general the external surface of the second screen 10' is placed parallel to the wall of the housing 5. In such embodiment a window 12 in the screen 10 is made in order to lead through it the terminal 4 and the screen overlapping the base structure is connected with the base 2 through an insulating holder 13.

In the second embodiment of the invention (fig.2) where the electronic element 1 or elements are placed on the both sides of the base structure 2 the first screen 10 is overlapping the radiator 8 and extend on the side of the control terminal 4 by a second screen 10' in order to overlap the radiator 8 placed on the other side of the base structure 2. In general the external surface of the second screen 10' is placed parallel to the wall of the housing 5. In such embodiment windows 12 are made in in the second screen 10' in order to lead through it the terminal 4.

In the both embodiments of the invention the radiator(s) have a galvanic connection to define voltage potential. The difference in voltage between power electronic elements and the screen is negligible in reference to the ground potential. Therefore, any imperfections in assembly or mounting elements, which may have sharp edges or elements are shielded.

## Claims

**1.** Conductive screen for power electronic elements enclosed in an insulating medium having a base structure (2) with at least one power electronic element (1) placed on at least one side of the base structure (2), having a conductive metal screen (10) placed in insulating medium (6) and overlapping the power electronic element (1), **characterized in that** the power electronic element (1) is electrically connected with a heat radiator (8) having an external surface (8a) on which a first conductive screen (10) is placed generally parallel to one wall of the housing (5) and the first conductive screen is electrically connected with high voltage potential derived through a HV terminal (3); the conductive screen is adapted for shaping an electric field distribution between the potential of the screen (10) and a ground potential of the housing (5) filled-in with the insulating medium (6) and the screen (10) is attached to the external flat surface (8a) of the heat radiator (8) in such a way that the sharp edges of the radiator (8) and the power electronic device (1) are encircled by the screen (10) and by a second conductive screen (10') which is placed in the insulating medium (6) generally parallel to the other wall of the housing (5); the second screen (10') is electrically connected with the first screen (10).

**2.** Conductive screen according to claim 1, **characterized in that** power electronic elements (1) are placed on two opposite side of the base structure (2) and the first screens (10) which are placed on the radiators (8) are electrically connected with themselves through the second screen (10').

**3.** Conductive screen according to claims 1-2, **characterized in that** the radiator (8) is made of copper or copper alloy or aluminum.

**4.** Conductive screen according to claims 1-2, **characterized in that** the first and second screen are carried out as a mesh or a perforated sheet.

**5.** Conductive screen according to any previous claims, **characterized in that** the screens (10, 10') are made of copper, cooper alloy, brass, aluminum or a composite electrically conductive material.

**4.** Conductive screen according to any previous claims, **characterized in that** the second screen (10') is provided with the window or windows (12) for placing in it the control terminals (4).

**5.** Conductive screen according to any of the previous claims, **characterized in that** the insulating medium is a solid state medium such as epoxy resin, silicone or thermoplastic.

**6.** Conductive screen according to any of the previous claims, **characterized in that** the insulating medium is liquid or gaseous medium.

**7.** Conductive screen according to any of the previous claims, **characterized in that** the housing (5) has a form of a solid steel structure, a structure assembled from metal sheets or a metal mesh.

**8.** Conductive screen for power electronic elements enclosed in an insulating medium according to any previous claims characterized that it is used in a tap changer of a high voltage transformer.

**9.** A tap changer having a screen according to any of claims 1-8, **characterized in that** it has at least one power electronic element (1) such as a thyristor, an IGBT transistor, a MOSFET transistor, a GTO thyristor, a diode or other power semi-conductive element.
